# EUROPEAN PATENT SPECIFICATION

(11) **EP 0 583 966 B1**
(45) Date of publication and mention of the grant of the patent: **28.05.1997**
(21) Application number: 93306455.2
(22) Date of filing: 17.08.1993
(51) Int. Cl.: H03G 3/20

(54) **Automatic gain control**
Automatische Verstärkungsregelung
Commande automatique de gain

(30) Priority: 20.08.1992 FI 923738
(43) Date of publication of application: 23.02.1994
(73) Proprietor: NOKIA MOBILE PHONES LTD., 24101 Salo (FI)
(72) Inventor: Juntti, Juhani, SF-41120 Puuppola (FI)
(74) Representative: Frain, Timothy John

(56) References cited:
- EP-A- 0 386 985
- GB-A- 2 243 733
- US-A- 4 928 258
- PATENT ABSTRACTS OF JAPAN vol. 11, no. 245 (E-531)11 August 1987

## Description

This invention relates to a method of producing an Automatic Gain Control (AGC) signal in a communications signal and a circuit arrangement therefor.

The encoding and decoding methods used in radio equipment, e.g. in digital mobile telephones in cellular networks, have been widely studied. The processing methods and circuit arrangements of the signals received by the receivers are closely related to the applications of these methods.

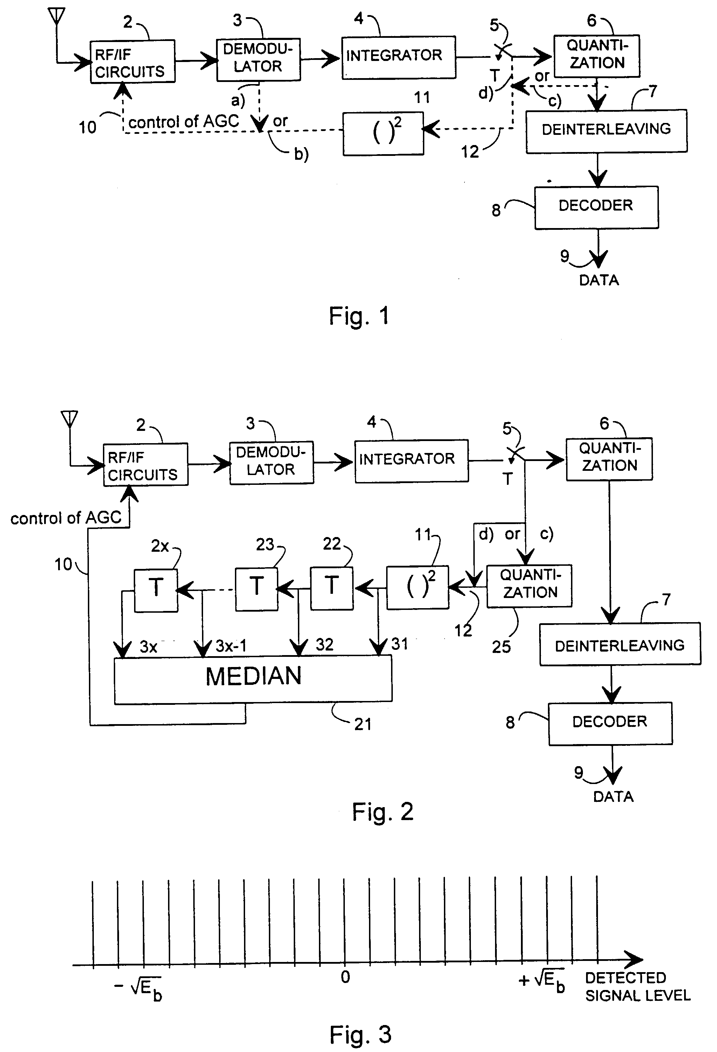

In traditional receivers, the AGC signal is obtained from the output of the detector or from the demodulator, as shown in Figure 1. The radio frequency circuits 2 of the receiver process or amplify and modify the signals received via the antenna 1 so that they can be processed in the demodulation circuit 3. The result of the demodulation is directed to the integrator 4, from the output of which samples are taken at symbol time intervals (T). The samples are directed further to a quantization circuit 6. The processing of the frames of the received digital signals or the discharge of multiplexing is done in circuit 7 and its output is directed to the decoder circuit 8, from the output of which the utility data 9, included in the signal received by the antenna 1, is obtained.

The gain of the RF/IF circuits 2 is adjusted by the AGC signal 10. The AGC signal 10 can be derived, e.g. in case a) by the demodulator 3, or in case b) from the signal obtained after integration 4. In the latter case, the signal can be taken from the output of sampling 5 in analogue form along route d) or from the output of the quantization circuit 6 in digital form along route c) and can be directed to the multiplier circuit 11 (quadrature), from the output of which the suitably processed AGC signal 10 will then be obtained.

In reception the interference caused by the pulse shaped signals cause a well-known problem which is difficult to resolve. The problem of pulsed interference signals has been studied earlier, e.g. in the article by K.R. Matis, J.W. Modestino: Performance of Selected Coded Direct-Sequence Receiver Structures in Pulsed Interference, Milcom 1985, vol. 3, Boston, MA. In this article the measurement principle of the interference is described but it is not shown how this measurement could be carried out. This source does not even disclose how the AGC signal is brought to follow the level of the utility information signal included in the received signal.

Decoding methods have been studied by simulation and their main results have been disclosed in the following sources: 1) J. Juntti: Performance Simulations of a Convolutionally Coded DS System in Pulsed Noise Interference, licentiate dissertation, University of Oulu, Electricity Department, May 1990; and 2) K. Jyrkkä: Performance Simulations of a Convolutionally Coded DS System in Pulsed CW Interference, diploma dissertation, University of Oulu, Electricity Department, November 1990. In these sources there are, however, no solutions for the way in which the AGC signal could in practice be made to follow, in an ideal way, the level of the information signal.

U.S. patent 4,906,928 discloses how to median filter detected data to eliminate pulsed interferences. The patent describes a fault finding apparatus for metal surfaces, whereby a radio transmitter and a receiver are used. The received signal is amplified to facilitate the detection of weak echos, and the receiver amplification is adjusted according to the level of the received signal. If the received signal is not in the 20 to 80 percent dynamic range of the A/D transformer the amplification is modified. This is simply an AGC amplification system whereby the signal is sought to be roughly set in the operative range of the A/D transformer. The AGC control signal itself is not filtered in any way.

British patent application (GB 2,243,733) describes demodulation of the signals in a Random Access Channel (RAC) of a General System Mobile (GSM) cellular communications base station. The problem differs from the other GSM channels in that the RAC is able to receive, within one given interval, signals from several mobiles. The arriving signals can show different levels and then the AGC must be adjusted according to the signal to be received. In this document the problems have been solved so that during a given time frame the strongest of the arriving signals is received and the level of the AGC amplifier is adjusted accordingly. The adjustment of the AGC amplifier level is done by detecting the amplitudes of the eight first bits of the frame and calculating their average to enhance precision. This document does not disclose median filtering the AGC signal.

The averaging of the AGC signal in order to cut the noise influences belongs as such to the old, well-known technology that has nothing to do with median filtering.

According to a first aspect of the present invention there is provided a method of producing an Automatic Gain Control (AGC) signal for use in the reception of a received high-frequency signal, which AGC signal is directed to high-frequency input circuits to automatically adjust the amplification therein, **characterized** by the AGC signal being median filtered prior to being directed to the input circuits.

According to a second aspect of the present invention there is provided a communications signal receiver comprising a receiver and amplifier circuit coupled to signal processing circuits, and a feed-back loop coupled between the signal processing circuits and the receiver and amplifier circuit characterized in that the feed-back loop comprises a median filter.

An advantage of the invention is the provision of a circuit arrangement wherein the AGC signal can be produced in a radio frequency receiver so that it would follow, in an optimised way, the level of the information signal.

It would not be obvious to a person skilled in the art to adopt median filtering of an AGC signal as this step requires extensive research, simulation and testing to ensure that the AGC signal is not distorted by noise or changes in signal level.

A central idea of the invention thus comprises the formation of the AGC control signal via median filtering.

An embodiment of the present invention is now described, by way of example, with reference to the accompanying drawings, in which:
Figure 1 shows a circuit arrangement for forming an AGC signal in accordance with the prior art;
Figure 2 shows a circuit arrangement in accordance with the present invention; and
Figure 3 shows an illustration of the setting of the quantifying levels in connection with the filtering used in the circuit arrangement of Figure 2.

Fig. 2 shows the circuit arrangement in accordance with the invention for the formation of an AGC signal. The circuit arrangement has only been shown as a basic block diagram and the same reference numbers indicate the same circuits as in Fig. 1. In accordance with the invention, the AGC signal is filtered by a median filter 21 with which the pulsed interferences of the signal, received by the antenna 1, are eliminated. In this connection it is understood that the term median filter will also be used for any modified median filter.

The signal is directed to median filtering from the output of switch 5. Fig. 2 shows two alternative ways to direct the signal 12 by the route c) via the quantisation circuit 25 or, via the alternative route d) direct to the quadrature circuit 11. The output of the multiplier circuit 11 is directed via the delay chain 22, 23,..., 2x as signals 31, 32,..., 3x-1, 3x to the median filter 21. The output signal 10 of the median filter corresponds to the AGC signal of Fig. 1.

The median filter allows a control that almost ideally follows the level of the information signal. The control signal is not sensitive to fast level changes, the contrary being true e.g. for averaging. This is why median filtering efficiently eliminates the influence of pulsed interference in reception.

In connection with the AGC control principle in accordance with the invention, it is preferable to use a soft decision decoder or at least a three-level quantization.

Usually a digital filter is used. Then, the quantization by the circuit 25 has to be done with a sufficient number of quantization levels Binary Phase Shift Keying (BPSK) modulation that has been illustrated in Fig. 3. Fig. 3 shows the level of the detected signal on the horizontal axis, whereby the indication E_{b} in the figure indicates the bit energy comparable with the amplitude. In the signal range √E_{b} ... + √E_{b} there could thus be e.g. at least three, preferably eight, or even more preferably e.g. 16 quantization levels, as in Fig. 3. Then a convolution code is generally used. Then the quantization of Fig. 2 is carried out by circuit 25 with a larger number of quantization levels, when as the corresponding signal in Fig. 1 was obtained directly from the circuit 6 with a lower number of levels. In principle, the median filtering can also be carried out in analogue form as shown for example in signal route d in Figure 2. Alternatively, it is possible to use a soft decision decoder in connection with the AGC principle in accordance with the invention.

The receiver may also be a Direct Sequence (DS) spread spectrum receiver, whereby the compilation of the signal is done before the demodulator, using a correlation principle where a correlator, a matched filter or an integrate-dump detector could be used.

The method and the circuit arrangement in accordance with the invention can advantageously be used when a linear metric and an interference estimate is used in decoding, whereby it is specifically required that the AGC ideally follows the level of the information signal. This is so e.g. in our parallel patent application "Decoding Using a Linear Metric and Interference Estimate" where the principle of this invention is applied to the decoding system of the received signal, whereby the AGC signal will in an ideal way follow the level of the information signal.

In view of the foregoing it will be clear to a person skilled in the art that modifications may be incorporated without departing from the scope of the present invention which is defined by the appended independent claims 1 and 6, with advantageous embodiments being represented by the appended dependent claims.

## Claims

1. A method of producing an Automatic Gain Control (AGC) signal for use in the reception of a received high-frequency signal, which AGC signal is directed to high-frequency input circuits (2) to automatically adjust the amplification therein, **characterized** by the AGC signal being median filtered (21) prior to being directed to the input circuits.

2. A method according to claim 1, wherein the signal is quantized with at least three-level quantization prior to being directed to median filtered.

3. A method as claimed in claim 2, wherein the signal is quantized with eight level quantization prior to being median filtered.

4. A method as claimed in claim 1, wherein the signal is not quantized prior to being median filtered.

5. A method as claimed in claim 1, wherein soft decision decoding of the signal is utilized prior to median filtering.

6. A communications signal receiver comprising a receiver and amplifier circuit (2) coupled to signal processing circuits (3,4), and a feed-back loop (10...23) coupled between the signal processing circuits and the receiver and amplifier circuit characterized in that the feed-back loop comprises a median filter (21).

7. A communications signal receiver as claimed in claim 6, wherein the feed-back loop comprises a quantization circuit between the signal processing circuits and the median filter.

8. A communications signal receiver as claimed in claim 6 or claim 7, wherein feed-back loop comprises a delay chain between the signal processing circuits and the median filter.

## Patentansprüche

1. Verfahren zur Bildung eines automatischen verstärkungsregelsignals (AGC) zur Verwendung beim Empfang eines Hochfrequenzsignals, wobei das AGC-Signal an Hochfrequenz- Eingangsschaltungen anliegt, um deren Verstärkung automatisch zu regeln, **dadurch gekennzeichnet**, daß das AGC-Signal medianwertgefiltert wird, bevor es an die Eingangsschaltungen angelegt wird.

2. Verfahren nach Anspruch 1, bei dem das Signal durch eine wenigstens Drei-Stufen-Quantisierung quantisiert wird, bevor es medianwertgefiltert wird.

3. Verfahren nach Anspruch 2, bei dem das Signal durch eine Acht-Stufen-Quantisierung quantisiert wird, bevor es medianwertgefiltert wird.

4. Verfahren nach Anspruch 1, bei dem das Signal vor der Medianwertfilterung nicht quantisiert wird.

5. Verfahren nach Anspruch 1, bei dem das Signal vor der Medianwertfilterung mit bewerteten Entscheidungen decodiert wird.

6. Kommunikationssignalempfänger mit einer Empfangs- und Verstärkerschaltung, die mit signalverarbeitenden Schaltungen gekoppelt ist, und mit einem Rückkopplungszweig zwischen den signalverarbeitenden Schaltungen und der Empfangs- und Verstärkerschaltung, **dadurch gekennzeichnet**, daß der Rückkopplungszweig ein Medianwertfilter enthält.

7. Kommunikationssignalempfänger nach Anspruch 6. bei dem der Rückkopplungszweig eine Qantisierungsschaltung zwischen den signalverarbeitenden Schaltungen und dem Medianwertfilter enthält.

8. Kommunikationssignalempfänger nach Anspruch 6 oder 7, bei dem der Ruckkopplungszweig zwischen den signalverarbeitenden Schaltungen und dem Medianwertfilter eine Verzögerungskette enthält.

## Revendications

1. Procédé pour produire un signal de commande automatique de gain (CAG) destiné à être utilisé dans la réception d'un signal reçu à haute fréquence, lequel signal de CAG est appliqué à des circuits d'entrée à haute fréquence pour ajuster automatiquement leur gain d'amplification, caractérisé par le fait que le signal de CAG est soumis à un filtrage médian avant d'être fourni aux circuits d'entrée.

2. Procédé selon la revendication 1, dans lequel le signal est quantifié avec au moins trois niveaux de quantification avant d'être fourni au filtre médian.

3. Procédé selon la revendication 2, dans lequel le signal est quantifié avec huit niveaux de quantification avant d'être fourni au filtre médian.

4. Procédé selon la revendication 1, dans lequel le signal n'est pas quantifié avant d'être fourni au filtre médian.

5. Procédé selon la revendication 1, dans lequel un décodage par décision logicielle du signal est utilisé avant le filtrage médian.

6. Récepteur de signaux de communications comprenant un circuit récepteur et amplificateur couplé à des circuits de traitement de signaux, et une boucle de rétroaction couplée entre les circuits de traitement de signaux et le circuit récepteur et amplificateur, caractérisé en ce que la boucle de rétroaction comprend un filtre médian.

7. Récepteur de signaux de communications selon la revendication 6, dans lequel la boucle de rétroaction comprend un circuit de quantification entre les circuits de traitement de signaux et le filtre médian.

8. Récepteur de signaux de communications selon la revendication 6 ou 7, dans lequel la boucle de rétroaction comprend une chaîne à retard entre les circuits de traitement de signaux-et le filtre médian.
